# EUROPEAN PATENT APPLICATION

(11) **EP 3 627 142 A1**
(43) Date of publication of application: **25.03.2020**
(21) Application number: 19197939.2
(22) Date of filing: 18.09.2019
(51) Int. Cl.: G01N 21/88

(54) **AUTOMATED OPTICAL INSPECTION EQUIPMENT WITH ADJUSTABLE IMAGE CAPTURING COMBINATION AND IMAGE CAPTURING COMBINATION ADJUSTING METHOD**

(30) Priority: 21.09.2018 TW 107133500
(71) Applicant: CENZ Automation Co. Ltd., New Taipei City 235, Taiwan (R.O.C.) (TW)
(72) Inventor: LIN, Chyi-Yeu, 111 Taipei City (TW); HO, Chien-Chiao, 820 Kaohsiung City (TW)
(74) Representative: Becker & Kurig Partnerschaft Patentanwälte PartmbB

(57) **Abstract**

An automated optical inspection (AOI) equipment (1, 2, 3, 4) with adjustable image capturing combination (159) and an image capturing combination adjusting method thereof are provided. The automated optical inspection equipment (1, 2, 3, 4) includes at least one image capturing apparatus (110, 111, 112), at least one moveable light source (130, 131, 132, 133, 134) and a device-under-test (DUT) movement mechanism (120, 121, 122, 123, 124, 125, 126, 127, 128, 1291, 1292). A control circuit (170) moves device under test (DUT), selects one light source (130, 131, 132, 133, 134), and controls the light source (130, 131, 132, 133, 134) to move or rotate. The control circuit (170) is capable of performing the capturing operation by switching multiple image capturing combinations (159) sequentially. Each of the image capturing combinations (159) records the image capturing apparatus (110, 111, 112), the position and angle of the device under test (DUT), the light source (130, 131, 132, 133, 134) and its position and angle relative to device under test (DUT). The positions or angles of capturing combinations are different. Accordingly, a large number of the image capturing results can be obtained for the device under test (DUT) quickly and automatically.

## Description

### TECHNICAL FIELD

The disclosure relates to an optical inspection technique, and more particularly to an automated optical inspection (AOI) equipment with adjustable image capturing combination and an image capturing combination adjusting method thereof.

### BACKGROUND

Automated optical inspection (AOI) combines optical sensing, visual recognition, mechanism drive and electronic control systems and other techniques to replace traditional manual visual inspection of the defects of a device under test. These devices under test could be mobile phones, printed circuit boards (PCBs), display panels, touch panels, and other types of products or components. From this, it is known that the products for automated optical inspection applications are quite extensive. According to the type and the production process of a device under test (DUT), the defects of DUTs may be different. Therefore, how to determine the corresponding image capturing setting for each of the device under test is an important part of the inspection process. To save time, the industry may build a series of automated optical inspection lines including multiple sets of automated optical inspection stations on mass production lines. Specific camera/lens and light source will be disposed in each set of the automated optical inspection station with a specific position of DUT, to sequentially capture an under-test image, so as to execute an automated optical inspection software and view the defects of the DUT. For example, a set of lenses and light sources are disposed at a certain distance beside a conveyor belt. The specifications, position and/or angle of the set of lenses and light sources at different inspection points are different. Also, the conveyor belt drives the DUT to sequentially go through each inspection point, and the camera captures an image of the DUT at the inspection point. Under the consideration of a small amount of production and saving the cost of automated optical inspection lines, the operator may build an automated optical inspection station that can run multiple inspection items. These inspection stations may need multiple groups of lens and light source, and each group of lens and light source will take turns to form image capturing combinations and then sequentially capture the image of the device under test. However, the position or angle of each group of lens and light source, and the image capturing position of the DUT are adjusted and fixed manually after research.

Before performing automated optical inspection, it is necessary to complete the construction of the two systems, including the image capture operation and an automated optical inspection software. In the process of image capturing, you need to decide which combination of camera, lens, under-test position and under-test angle to be configured for the DUT. The automated optical inspection software performs various types of inspection analysis on an under-test image captured from the device under test via the image capturing combinations. If the under-test image clearly shows what needs to be inspected, the programing of the automated optical inspection software is not difficult. What is difficult is how to make the under-test image of the DUT clearly shows what needs to be inspected. For example, the surface defects of a mobile phone case may be very small and not obvious. For a type of camera/lens, one must try to make the DUT appear differently relative to the camera's position and angle, and under the variations of different light sources and positions/angles to obtain usable image capturing results. Therefore, for many products, the biggest challenge in automated optical inspection engineering is how to determine image capturing settings to obtain the appropriate image capturing results, and it will take a lot of time on this. The reason is that, in the conventional technology, the operator needs to first fix the camera/lens to the image capturing stand, fix a certain light source at a certain position with a certain angle relative to the camera, and fix the DUT at a certain position with a certain angle relative to the camera. The time spent on adjustment may take a few minutes to several dozens of minutes. After each of the image capturing operation, if the inspector is not satisfied with the image capturing results, relevant settings need to be re-adjusted. Repeating this is quite time consuming. The automated optical inspection project for the surface defects of a newly produced mobile phone often includes dozens of automated optical inspection stations, and the construction project can last for several months. Among them, most of the time is spent on the combination of the camera, the lens, the light source, and the position/angle of the DUT. There may be thousands of combinations, and dozens of combinations will be picked out as final combinations from these combinations. Therefore, this kind of traditional automated optical inspection image capturing project that relies on manual adjustment is obviously inefficient and needs to be improved.

After the setup of the traditional manual adjustment of the image capturing, a fast automated optical inspection line (which includes multiple inspection stations) can be established in various combinations. Or, establish a multi-project inspection station that can perform multiple inspection projects at the same station. However, the establishment of these two requires the establishment of various related cameras, lenses, light sources, DUT fixing mechanisms and so on at each inspection station of the same inspection line, or an inspection station that can perform multiple inspection items. All of these will lead to extra costs.

### SUMMARY

In view of the above, the disclosure provides an automated optical inspection (AOI) equipment with adjustable image capturing combination and an image capturing combination adjusting method, which can automatically and quickly change different lenses, positions and angles of a device under test (DUT), different light sources and corresponding positions/angles to shoot. Accordingly, it can quickly get a lot of image capturing results from a large number of image capturing combinations.

The automated optical inspection equipment with adjustable image capturing combination of the disclosure is configured for capturing an image of a device under test and inspecting the content of the captured image. The automated optical inspection equipment includes a body, an image capturing apparatus, a light source, a DUT movement mechanism, and a control circuit. The image capturing apparatus is disposed on the body. The light source is movably disposed on the body. The device-under-test movement mechanism is disposed on the body and is provided for the placement of the device under test. The control circuit connects the image capturing apparatus, the light source, and the DUT movement mechanism to control the DUT movement mechanism to move the DUT and control the light source movement, and sequentially switch each of the several image capturing combinations to perform an image capturing operation. Each of the image capturing apparatuses records the image capturing apparatus, an under-test position to and an under-test angle of the DUT, the type of the light source and the position and angle of the light source relative to the DUT. The parameters included in different image capturing combinations are different.

In an embodiment of the disclosure, there are multiple image capturing apparatuses. Those image capturing apparatuses are movably disposed on the body. The control circuit selects one of those image capturing apparatuses to perform an image capture operation toward the DUT. Each of the image capturing combinations records an image capturing apparatus, and the specifications of the image capturing apparatus and the paired lenses are different.

In an embodiment of the disclosure, there are multiple light sources. The control circuit selects one of those light sources to move, the selected light source would be turned on and face toward the DUT. Each of the image capturing combinations further records the position of the light sources and position of the light sources relative to the DUT. The light sources provide different brightness distributions.

In an embodiment of the disclosure, the control circuit controls the multi-axis movement of the light sources.

In an embodiment of the disclosure, the control circuit screens the image capturing combinations according to the image capturing results of the image capturing combinations, and selects an inspection combination for an inspection operation according to the image capturing results of the selected image capturing combinations. Each of the inspection combinations records the image capturing apparatus, the under-test position and the under-test angle, and the type of light source and the position and angle of the light source relative to the DUT. The inspection operation is configured for evaluating the defects of the DUT.

In an embodiment of the disclosure, the control circuit determines whether the image capturing results of the image capturing combinations are suitable for the inspecting operation, retains the image capturing combinations suitable for the inspecting operation, and eliminates the image capturing combinations that are not suitable for the inspection operation.

The image capturing combination adjusting method of the disclosure is suitable for the optical inspection equipment to inspect the DUT. This image capturing combination adjusting method includes the following steps. The image capturing apparatus is controlled and activated. The movement of the light source of the automated optical inspection equipment is controlled to face toward the DUT. The DUT is controlled to move to the under-test position. Each image capturing combination is sequentially switched to perform an image capture operation. Each image capturing combination records the image capturing apparatus and a position and an angle of the light sources relative to the DUT, and the under-test position or the under-test angle of the DUT. The position and angle included by the different image capturing combinations are different.

In an embodiment of the disclosure, the image capturing apparatus includes multiple image capturing apparatuses movably disposed in the body. The image capturing combination adjusting method further includes the following steps. One of the image capturing apparatuses is selected to perform the image capturing operation toward the DUT. Each image capturing combination further records an image capturing apparatus, and the image capturing apparatuses have different lens specifications.

In an embodiment of the disclosure, the light source includes multiple light sources, and the step of controlling the movement of light source of the optical inspection equipment includes the following step. One of the light sources is selected to be turned on and face toward the DUT. Each of the image capturing combinations further records a light source, and the light sources provide different brightness distributions.

In an embodiment of the disclosure, the step of controlling the movement of the light source of the optical inspection equipment includes the following step. Light source is controlled to move in multi-axis.

In an embodiment of the disclosure, the step of sequentially switching of each image capturing combination to perform the image capturing operation further includes the following steps. The image capturing combinations are screened according to the image capturing results of the image capturing combinations. An inspection combination for the use of the inspection operation is selected according to the image capturing results of the screened image capturing combinations. Each inspection combination records the image capturing apparatuses, the position and angle of the light source relative to the DUT, the under-test position and the under-test angle of the DUT. The inspecting operation is configured for evaluating the defects of the DUT.

In an embodiment of the disclosure, the step of screening the image capturing combinations according to the image capturing results of the image capturing combinations includes the following steps. Whether the image capturing results of the image capturing combinations are suitable for the inspection operation are determined. The image capturing combinations suitable for the inspection operation is retained, and the image capturing combinations that are not suitable for the inspection operation is eliminated.

According to the above, the automated optical inspection equipment with adjustable image capturing combination and the image capturing combination adjusting method thereof can quickly switch all image capturing combinations to quickly obtain image capturing results of a large number of different image capturing combinations. Moreover, screen the appropriate image capturing combinations according to the image capturing results. After the parameters of these image capturing combinations are further slightly adjusted, the inspection combinations configured for subsequent inspection operations are obtained according to the slightly adjusted image capturing results. In this way, not only the appropriate inspection combinations can be quickly determined, they can also be configured for inspection operations.

In order to make the features and advantages of the disclosure comprehensible, embodiments with reference to drawings are elaborated in detail below.

### BRIEF DESCRIPTION OF THE DRAWINGS

FIG. 1 is a block diagram of components of an optical inspection equipment according to an embodiment of the disclosure.
FIG. 2 is a flow chart of an image capturing combination adjusting method according to an embodiment of the disclosure.
FIGs. 3A to 3D are schematic diagrams of the optical inspection equipment according to the first embodiment of the disclosure.
FIGs. 4A to 4E are schematic diagrams of the optical inspection equipment according to the second embodiment of the disclosure.
FIGs. 5A to 5D are schematic diagrams of the optical inspection equipment according to the third embodiment of the disclosure.
FIG. 6 is a flow chart of an inspection combination selection method according to an embodiment of the disclosure.

### DESCRIPTION OF THE EMBODIMENTS

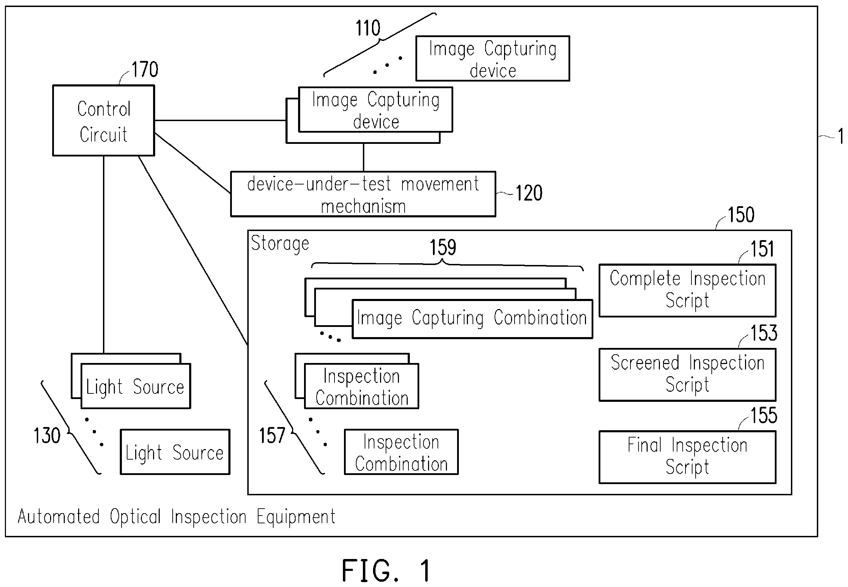

FIG. 1 is a block diagram of components of an optical inspection equipment 1 according to an embodiment of the disclosure. With reference to FIG. 1, the optical inspection equipment 1 includes, but is not limited to, one or more image capturing apparatuses 110, a device-under-test movement mechanism 120, one or more light sources 130, a storage 150 and a control circuit 170.

Each image capturing apparatus 110 is movably disposed on a body of the optical inspection equipment 1. The image capturing apparatuses 110 may be a camera, a video camera, etc. Also, the image capturing apparatuses 110 may include an image sensor (for example, a charge coupled device (CCD), a complementary metal-oxide-semiconductor (CMOS), an optical lens, an image control circuit and other components. In the embodiment of the disclosure, the lens specifications of the image capturing apparatuses 110 (for example, image capturing aperture, magnification, focal length, field of view, image sensor size, etc.) are different, and the number thereof can be adjusted according to actual needs.

The device-under-test movement mechanism 120 is disposed on the body of the optical inspection equipment 1, and the device under test can be placed thereon. The device-under-test movement mechanism 120 may be a mechanical arm, a height adjustment table, a slide rail, a rotating table, a screw rod, a motor, a cylinder or various types of combination of mechanical components that may drive connecting components to move or rotate, so that the placed device under test may lift, lower, move, and/or rotate. It should be noted that, the device-under-test movement mechanism 120 of the embodiment of the disclosure is integrated with the body of the optical inspection equipment 1. However, in other embodiments, the device-under-test movement mechanism 120 may be separated with the optical inspection equipment 1 as a separate device.

Each of the light sources 130 is movably disposed on the body of the optical inspection equipment 1. The light sources 130 may be various types of light sources, such as a coaxial light source, a backlight source, a ring cover light source, a strip light source, a point light source, or a border rotatable light source formed by a strip light source. The light sources 130 may move relative to the body of the optical inspection equipment 1 in one, two or more axes. For example, light sources 130 may be lifted, lowered, moved, and/or rotated. In addition, the number of light sources 130 may be adjusted according to actual needs, and the brightness distribution provided by these light sources 130 may also be adjusted.

A storage 150 may be any type of fixed or movable random access memory (RAM), read only memory (ROM), flash memory, traditional hard disk drive (HDD), solid-state drive (SSD) or similar components, and may be configured to record program codes, software modules, inspection scripts (for example, a complete inspection script 151, a screening inspection script 153, a final inspection script 155, etc.), an inspection combination 157, an image capturing combination 159, image capturing results of the image capturing apparatuses 110 (that is, images), an image recognition algorithm, a driver of the device-under-test movement mechanism 120 and other information or files. Detailed description thereof is provided in the embodiments below.

A control circuit 170 is coupled to the image capturing apparatuses 110, the device-under-test movement mechanism 120, the light sources 130, and a storage 150. The control circuit 170 may be a central processing unit (CPU), a microcontroller, a programmable controller, an application-specific integrated circuits (ASICs), a chip or other similar components or combinations of the above components. In the embodiment of the disclosure, the control circuit 170 controls all operations of the optical inspection equipment 1. For example, the control circuit 170 drives the device-under-test movement mechanism 120, and controls the functions of the image capturing apparatuses 110 and the light sources 130 (for example, turning on/off, shooting, light and dark, movement in at least one axial, etc.). In addition, the control circuit 170 can access and load the software, data or files recorded by the storage 150.

For ease of understanding of the operation process of the embodiments of the disclosure, several embodiments will be provided below to describe the flow of the use of the optical inspection equipment 1 in the embodiment of the disclosure. Hereinafter, the method described in the embodiments of the disclosure will be described together with each of the devices, components, and modules in the optical inspection equipment 1. Each of the flows of the method may be adjusted according to actual implementation scenarios, and the disclosure is not limited thereto.

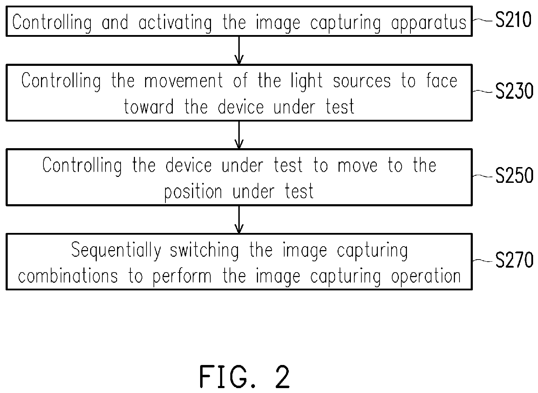

FIG. 2 is a flow chart of an image capturing combination adjusting method according to an embodiment of the disclosure. With reference to FIG. 2, the optical inspection equipment 1 may include two or more image capturing apparatuses 110 (the specifications of the pairing lenses are different). These image capturing apparatuses 110 can move, rotate and perform other actions in at least one axis, and are movably disposed on the body of the optical inspection equipment 1. The control circuit 170 can activate certain image capturing apparatuses 110, and control the activated image capturing apparatuses 110 to move, rotate and perform other actions in at least one axis, to face toward the device under test and perform an image capturing operation (step S210).

In addition, the control circuit 170 controls the movement of the light sources 130 to face toward the device under test (step S230), and controls the device-under-test movement mechanism 120 to make the device under test move (step S250). Specifically, the control circuit 170 may select and turn on a certain light source 130 (each of the light sources 130 is different) or control it to move, rotate or perform other actions in at least one axis. Alternatively, the control circuit 170 may control the device-under-test movement mechanism 120 to move or rotate the device under test to a designated position (that is, the under-test position and the angle) and select a certain light source 130 and control it to move to a specific position with an angle relative to the device under test. Also, if the optical inspection equipment 1 includes more than two light sources 130, the control circuit 170 selects one of the light sources 130 to turn on and face toward the device under test, so that other light source 130 are turned off or do not affect the irradiation of the selected light source 130 toward the device under test.

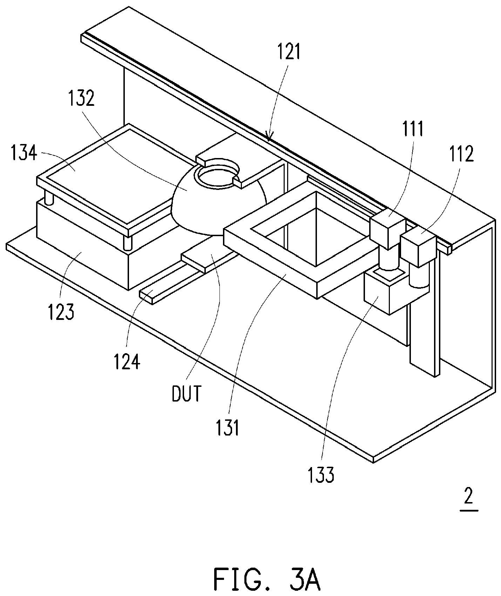

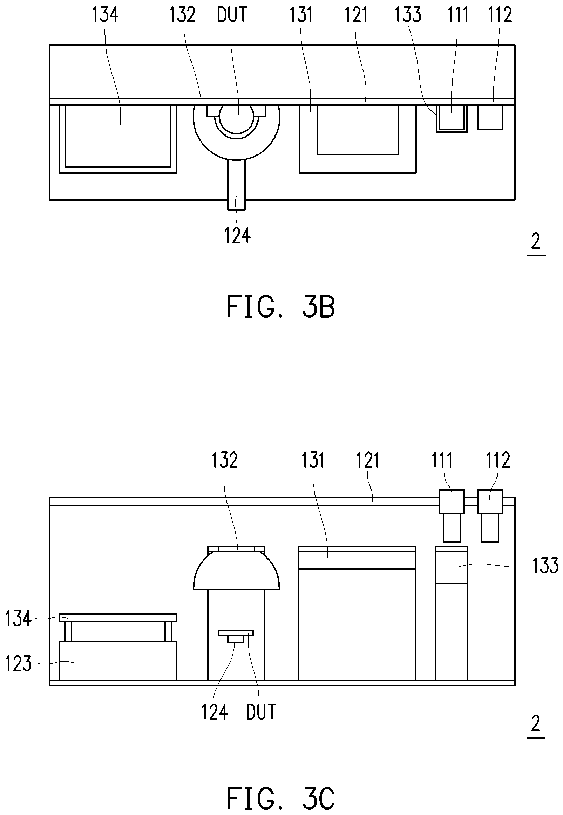

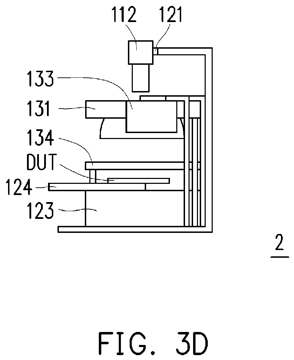

For example, FIG. 3A to FIG. 3D are schematic diagrams of an optical inspection equipment 2 according to the first embodiment of the disclosure. With reference to FIGs. 3A to 3D, the optical inspection equipment 2 includes two image capturing apparatuses 111 and 112 (different fields of view). The device-under-test movement mechanism 120 includes a slide rail 121 to drive the image capturing apparatuses 111 and 112 to move horizontally, a height adjustment table 123 to adjust the top side height, and a mechanical arm 124 to drive the device under test *DUT* to move. The light source 130 includes a border rotatable light source 131, a ring cover light source 132, a coaxial light source 133 and a backlight source 134. As shown in FIG. 3C, each light source 130 is located at a different position in the horizontal direction. In addition, the backlight source 134 may also be lifted and lowered by the height adjustment table 123. With reference to FIGs. 3B and 3C, the control circuit 170 may control the corresponding image capturing apparatuses 111 and 112 to move above the corresponding light source 130 (shown as the ring cover light source 132). The mechanical arm 124 drives the device under test *DUT* to a specific position above or below the corresponding light source 130 and rotate the device under test *DUT* toward a specific under-test angle. Next, the control circuit 170 turns on the specific light source 130 and performs shooting via the specific image capturing apparatuses 111 and 112, to complete the image capturing operation of a set of image capturing combination 159. Next, control circuit 170 switches to the next set of image capturing combination 159, and so on. The corresponding image capturing apparatuses 111 and 112 may move, or the mechanical arm 124 moves or rotates device under test *DUT.*

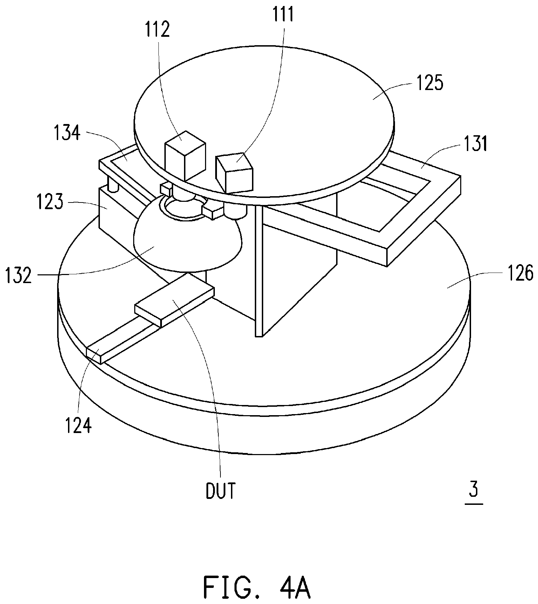

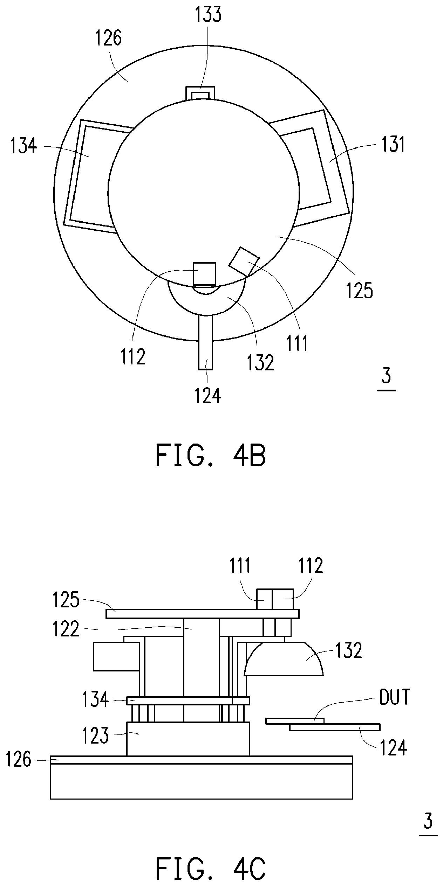

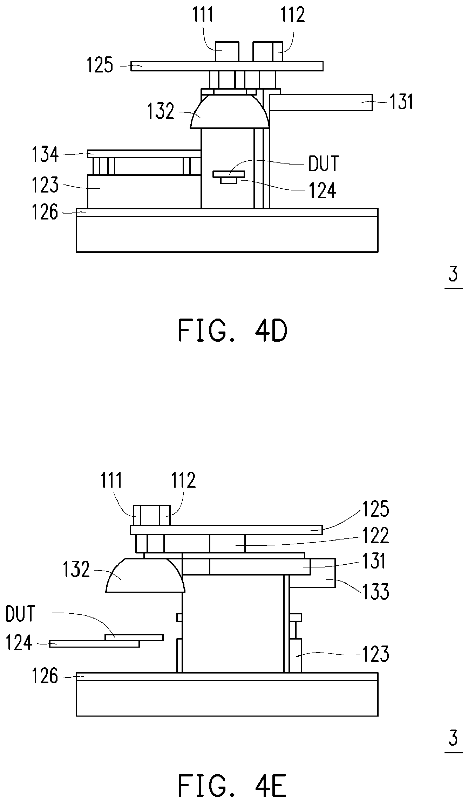

FIGs. 4A to 4E are schematic diagrams of an optical inspection equipment 3 according to the second embodiment of the disclosure. What is different from the first embodiment is that, as shown in FIGs. 4A to 4C, the optical inspection equipment 3 includes a rotary axis 122, an upper rotating table 125 and a lower rotating table 126. The upper rotating table 125 rotates around the rotary axis 122 and provides the disposal of the image capturing apparatuses 111 and 112. The lower rotating table 126 rotates around the rotary axis 122 and provides the disposal of each of the light sources 130. As shown in FIG. 4B, the disposal angles of each of the light sources 130 relative to the axis are different. With reference to FIGs. 4B and 4C, when the control circuit 170 uses a certain image capturing combination 159, the upper rotating table 125 and/or the lower rotating table 126 rotates so that the corresponding image capturing apparatuses 111 and 112 (shown as the image capturing apparatus 112) move above the corresponding light source 130 (shown as the ring cover light source 132), and the mechanical arm 124 drives the device under test *DUT* to a specific position below or above the corresponding light source 130 (for example, above the backlight source 134) and rotates the device under test toward a specific under-test angle. Next, the control circuit 170 switches to the next set of image capturing combination 159, and so on. The upper rotating table 125 and/or lower rotating table 126 may rotate, or the mechanical arm 124 may move or rotate the device under test DUT.

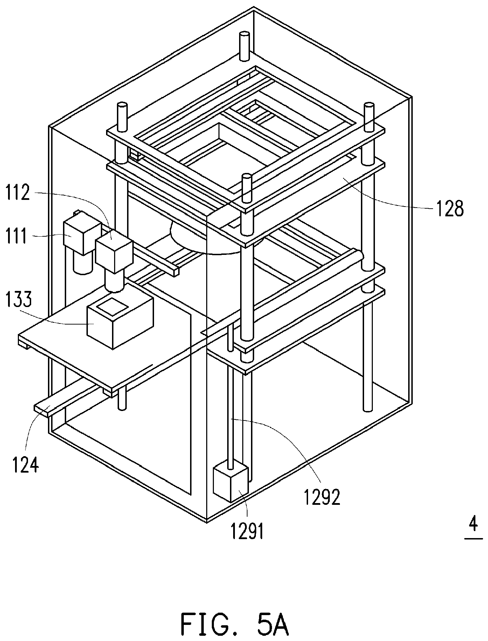

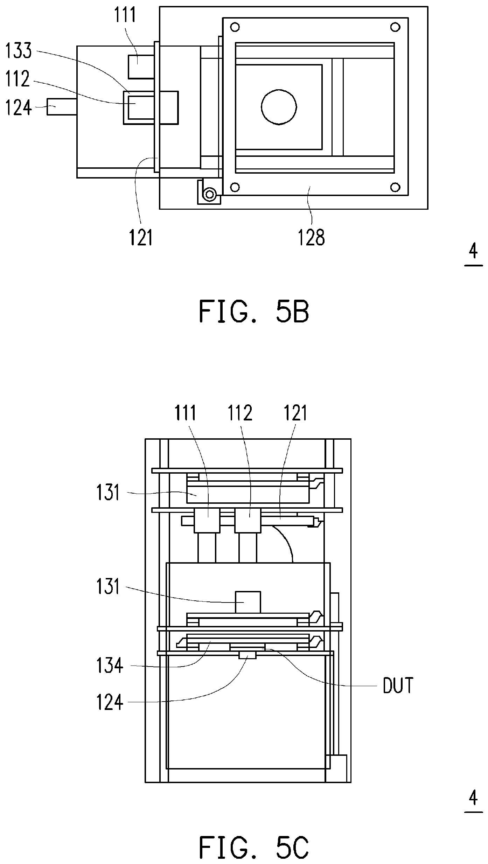

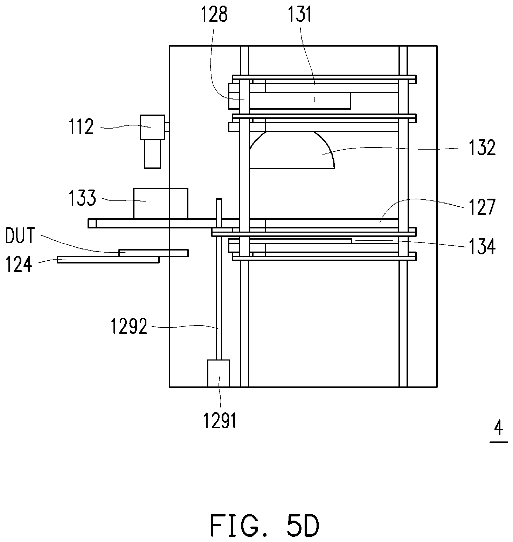

FIG. 5A to 5D are schematic diagrams of an optical inspection equipment 4 according to the third embodiment of the disclosure. What is different from the first embodiment is that, as shown in FIGs. 5A to 5D, the optical inspection equipment 4 includes a cylinder 127, a lifting table 128, and a motor 1291. The cylinder 127 can drive the flat plate corresponding to the light sources 130 to extend or retract. The lifting table 128 that can drive the flat plate corresponding to the light sources 130 to lift and lower. The motor 1291 that can drive a screw rod 1292 to rotate. With reference to FIGs. 5A and 5D, when the control circuit 170 uses a certain image capturing combination 159, the motor 1291 drives the screw rod 1292 to rotate so that the lifting table 128 drives the specific light source 130 (shown as the coaxial light source 133) lower to the position as shown in the drawing. The corresponding cylinder 127 pushes the light source 130 via the telescopic rod, so that the corresponding image capturing apparatuses 111 and 112 (shown as the image capturing apparatus 112) are directed toward the corresponding light source 130. The mechanical arm 124 drives the device under test *DUT* to a specific under-test position below or above the corresponding light source 130, and rotates the under-test *DUT* to a specific under-test angle. Next, the control circuit 170 switches to the next set of image capturing combination 159, and so on. The cylinder 127 may extend or retract the telescopic rod of the specific light source 130. The lifting table 128 may lift or lower the flat plate that supports the specific light source 130, or, the mechanical arm 124 moves or rotates the device under test *DUT.*

Next, the control circuit 170 sequentially switches each of the multiple image capturing combinations 159 to perform the image capturing operation on the device under test (step S270). Specifically, each of the image capturing combinations 159 records the position and the angle of the image capturing apparatus 110 and the light source 130 relative to the device under test. The parameters included in the different image capturing combinations 159 are different (for example, there are at least one is different with respect to the types, the under-test position and the under-test angle of the image capturing apparatus 110 and the light source 130 and the position and angel of the device under test relative to the image capturing apparatus 110 and the light source 130). In addition, if the optical inspection equipment 1 includes more than one image capturing apparatus 110 and/or the light source 130, each of the image capturing combinations records a specific image capturing apparatus 110 and/or a specific light source 130. The control circuit 170 may select the image capturing apparatus 110, the device-under-test movement mechanism 120 and/or the light source 130 by using each set of the image capturing combinations 159 according to the complete inspection script 151. As a result, the image capturing apparatus 110, the device-under-test movement mechanism 120 and/or the light source 130 perform at least one axial movement and capture an image of the device under test. Then, it switches to the next set of image capturing combination 159 to perform an image capturing operation (that is, shooting via the selected image capturing apparatus 110 after the image capturing device 110, the device-under-test movement mechanism 120 and/or the light source 130 are positioned). This operation goes on repeatedly until all the image capturing combinations 159 have been used. In other words, the control circuit 170 sequentially uses the specific image capturing apparatus 110, the specific light source 130 and the image capturing combinations 159 of the specific position/angle of the device under test to capture images of the device under test. All image capturing combinations 159 are used sequentially in the complete inspection script 151.

It is known that the embodiment of the disclosure can adjust any image capturing combination, and the image capturing combinations 159 can be quickly switched. The image capturing results of multiple different image capturing combinations can be obtained without manual adjustment, thereby improving efficiency. It should be noted that there are many options for the design of the device-under-test movement mechanism 120, the image capturing apparatus 110 and the light source 130. The options may be adjusted according to the actual requirements of a user, and are not limited by the disclosure.

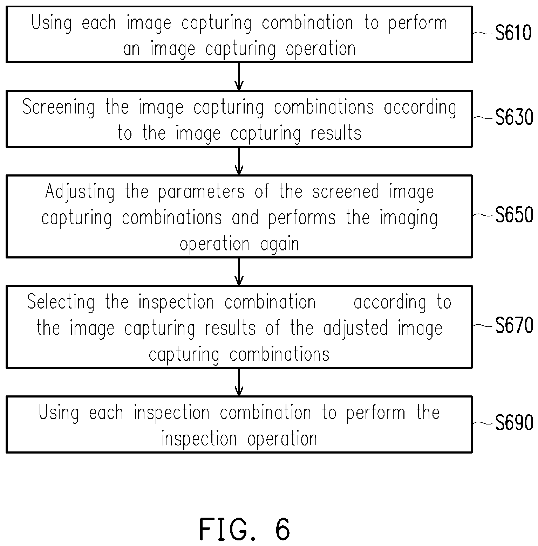

In addition to quickly switching the image capturing combinations 159, the optical inspection equipment 1 of the embodiment of the disclosure can further select an image capturing combination suitable for an inspection operation. FIG. 6 is a flow chart of an inspection combination selection method according to an embodiment of the disclosure. With reference to FIG. 6, the control circuit 170 uses each image capturing combination 159 as described in step S250 to perform an image capturing operation (step S610). Next, the control circuit 170 screens those image capturing combinations 159 according to the image capturing results (that is, the captured images) of those image capturing combinations 159 (step S630). Specifically, the control circuit 170 determines whether the image capturing results of those image capturing combinations 159 are suitable for the inspection operation via an image recognition technology. The control circuit 170 will retain those image capturing combinations 159 that are suitable for the inspection operation, record them in the screening inspection script 153, and eliminate those image capturing combinations 159 that are not suitable for the inspection operation. It should be noted that, the inspection operation refers to the evaluation of the defects of the device under test according to image processing and identification technology and the evaluation conditions suitable for the inspection operation may easily inspect defects. However, since different device under test may have different defects, the standard for determining the suitable inspection operation may be different. Users may adjust the screened evaluation conditions according to actual needs, and will not be limited by the disclosure.

In order to provide the image capturing combinations 159 that are more suitable for subsequent inspection operations, the control circuit 170 also adjusts the parameters of the screened image capturing combinations 159 and performs the imaging operation again (step S650). Specifically, the control circuit 170 sequentially uses each set of the screened (retained) image capturing combinations 159 according to the screening inspection script 153, and gradually adjusts the position and angle of the image capturing apparatuses 110 relative to the device under test of those screened image capturing combinations 159 via the device-under-test movement mechanism 120. The gradual adjustment here refers to every adjustment for specific spacing distance or differential specific angle. It should be noted that, according to different designs, in other embodiments, the control circuit 170 can also gradually adjust the illumination angle, brightness, and other parameters of the light source 130 via the device-under-test movement mechanism 120.

The control circuit 170 then selects the inspection combination 157 from these image capturing combinations 159 according to the image capturing results of the adjusted image capturing combinations 159 for use by the inspection operation (step S670). Specifically, the control circuit 170 can determine a more suitable combination for the inspection operation from a number of slightly adjusted screened image capturing combinations 159 according to the evaluation conditions which are the same or similar to the step S230. The control circuit 170 further uses the selected combination as the inspection combination 157, and records it in the final inspection script 155. It should be noted that, in other embodiments, if the inspection combination 157 is quickly obtained, after step S630, the control circuit 170 may directly use the screened image capturing combinations 159 as the inspection combination 157.

In addition, the optical inspection equipment 1 of the embodiment of the disclosure not only determines the inspection combination 157, the control circuit 170 also uses each of the inspection combinations 157 to perform the inspection operation on the device under test according to the final inspection script 155 (step S690). Each inspection combination 157 also includes at least one of those image capturing apparatuses 110, at least one of those light sources 130, the under-test position and under-test angle of the device under test after being driven by the device-under-test movement mechanism 120, and the position and angle of the device under test relative to those image capturing apparatuses 110. The final inspection script 155 sequentially uses each set or any set of inspection combinations 157 to perform inspection operation to evaluate whether the device under test is defective. That is, as long as the optical inspection equipment 1 of the embodiment of the disclosure can simultaneously complete the determination on the inspection combination and the inspection to the device under test. It should be noted that in some embodiments, the device-under-test movement mechanism 120 may further include a conveyor belt to carry several devices under test. The device-under-test movement mechanism 120 sequentially move the device under test to an area where the image capturing apparatuses 110 can capture the image.

According to the above, the automated optical inspection equipment with the adjustable image capturing combination and its image capturing combination adjusting method can quickly switch a large number of different image capturing combinations to obtain a large number of image capturing results. Next, the slightly adjusted screened image capturing combination can get the inspection combination used by the inspection operation. In the embodiment of the disclosure, the image capturing combination completely does not need to be manually adjusted. It can automatically determine the appropriate image capturing combination, and finally obtain the inspection combination which is most suitable for inspecting the operation, which obviously improves efficiency. In addition, the automated optical inspection equipment of the embodiment of the disclosure can also perform inspection operation according to these inspection combinations so that one machine can serve two purposes.

## Claims

1. An automated optical inspection (AIO) equipment (1, 2, 3, 4) with adjustable image capturing combination (159), used for inspecting a device under test (DUT), **characterized in that** the automated optical inspection equipment (1, 2, 3, 4) comprises:
a body;
at least one image capturing apparatus (110, 111, 112), disposed on the body;
at least one light source (130, 131, 132, 133, 134) movably, disposed on the body; and
a control circuit (170), connecting to the at least one image capturing apparatus (110, 111, 112) and the at least one light source (130, 131, 132, 133, 134), controlling and activating the at least one image capturing apparatus (110, 111, 112), controlling a movement of the at least one light source (130, 131, 132, 133, 134), sequentially switching each of a plurality of image capturing combinations (159) to perform an image capture operation on the device under test (DUT), wherein
each of the image capturing combinations (159) records positions and angles of the at least one of the image capturing apparatuses (110, 111, 112) and the at least one of the light sources (130, 131, 132, 133, 134) relative to the device under test (DUT), and the positions or the angles of the different image capturing combinations (159) are different.

2. The automated optical inspection equipment (1, 2, 3, 4) with the adjustable image capturing combination (159) according to claim 1, **characterized by** further comprising:
a DUT movement mechanism (120, 121, 122, 123, 124, 125, 126, 127, 128, 1291, 1292), disposed on the body for the device under test (DUT) to be placed, wherein the control circuit (170) controls the DUT movement mechanism (120, 121, 122, 123, 124, 125, 126, 127, 128, 1291, 1292) to make the device under test (DUT) move, and each of the image capturing combinations (159) further records an under-test position and an under-test angle of the device under test (DUT).

3. The automated optical inspection equipment (1, 2, 3, 4) with the adjustable image capturing combination (159) according to claim 1, **characterized in that** the at least one image capturing apparatus (110, 111, 112) comprises a plurality of image capturing apparatuses (110, 111, 112), the image capturing apparatuses (110, 111, 112) are movably disposed on the body, the control circuit (170) selects one of the image capturing apparatuses (110, 111, 112) to perform the image capturing operation toward the device under test (DUT), each of the image capturing combinations (159) further records one of the image capturing apparatuses (110, 111, 112), and the image capturing apparatuses (110, 111, 112) comprise at least one lens.

4. The automated optical inspection equipment (1, 2, 3, 4) with the adjustable image capturing combination (159) according to claim 1, **characterized in that** the at least one light source (130, 131, 132, 133, 134) comprises a plurality of light sources (130, 131, 132, 133, 134), the control circuit (170) selects one of the light sources (130, 131, 132, 133, 134) to move to a designated position and turns on the selected light source (130, 131, 132, 133, 134), and each of the image capturing combinations (159) further records one of the light sources (130, 131, 132, 133, 134) and a position and brightness distribution of the light sources (130, 131, 132, 133, 134).

5. The automated optical inspection equipment (1, 2, 3, 4) with the adjustable image capturing combination (159) according to claim 1, **characterized in that** the control circuit (170) controls the at least one light source (130, 131, 132, 133, 134) to move in multi-axis.

6. The automated optical inspection equipment (1, 2, 3, 4) with the adjustable image capturing combination (159) according to claim 1, **characterized in that** the control circuit (170) screens the image capturing combinations (159) according to the image capturing results of the image capturing combinations (159), and selects at least one inspection combination (157) for an inspection operation according to the image capturing results of screened image capturing combinations (159), wherein each of the inspection combinations (157) records the at least one image capturing apparatus (110, 111, 112) and the position and the angle of the at least one light source (130, 131, 132, 133, 134) relative to the device under test (DUT), and the inspecting operation is configured for evaluating defects of the device under test (DUT).

7. The automated optical inspection equipment (1, 2, 3, 4) with the adjustable image capturing combination (159) according to claim 6, **characterized in that** the control circuit (170) determines whether the image capturing results of the image capturing combinations (159) are suitable for the inspection operation, retains the image capturing combinations (159) suitable for the inspection operation, and eliminates the image capturing combinations (159) that are not suitable for the inspection operation.

8. An image capturing combination adjusting method, suitable for inspecting a device under test (DUT), and **characterized in that** the image capturing combination adjusting method comprises:
controlling and activating at least one image capturing apparatus (110, 111, 112);
controlling a movement of at least one light source (130, 131, 132, 133, 134), to face toward the device under test (DUT);
controlling the device under test (DUT) to move to an under-test position; and
sequentially switching each of the plurality of image capturing combinations (159) to perform an image capturing operation, wherein each of the image capturing combinations (159) records positions and angles of the at least one image capturing apparatus (110, 111, 112) and the at least one light source (130, 131, 132, 133, 134) relative to the device under test (DUT) and the under-test position and an under-test angle of the device under test (DUT), and the position or the angle of different image capturing combinations (159) are different.

9. The image capturing combination adjusting method according to claim 8, **characterized in that** the at least one image capturing apparatus (110, 111, 112) comprises a plurality of image capturing apparatuses (110, 111, 112) which are movable, and the image capturing combination adjusting method further comprises:
selecting one of the image capturing apparatuses (110, 111, 112) to perform the image capturing operation toward the device under test (DUT), wherein each of the image capturing combinations (159) further records one of the image capturing apparatuses (110, 111, 112), and the image capturing apparatuses (110, 111, 112) have different lens.

10. The image capturing combination adjusting method according to claim 8, **characterized in that** the at least one light source (130, 131, 132, 133, 134) comprises a plurality of light sources (130, 131, 132, 133, 134), and the step of controlling the movement of the at least one light source (130, 131, 132, 133, 134) comprises:
selecting one of the light sources (130, 131, 132, 133, 134) to turn on and face toward the device under test (DUT), wherein each of the image capturing combinations (159) further records one of the light sources (130, 131, 132, 133, 134), and the light sources (130, 131, 132, 133, 134) provide different brightness distributions.

11. The image capturing combination adjusting method according to claim 8, **characterized in that** the step of controlling the movement of the at least one light source (130, 131, 132, 133, 134) comprises:
controlling the at least one light source (130, 131, 132, 133, 134) to move in multi-axis.

12. The image capturing combination adjusting method according to claim 8, **characterized in that** the step of sequentially switching each of the image capturing combinations (159) to perform the image capturing operation further comprises:
screening the image capturing combinations (159) according to the image capturing results of the image capturing combinations (159); and
selecting at least one inspection combination (157) for an use of an inspection operation according to the image capturing results of the screened image capturing combinations (159), wherein each of the inspection combinations (157) records one of the image capturing apparatuses (110, 111, 112), the under-test position and the under-test angle of the device under test (DUT) and the position and angle of the at least one light source (130, 131, 132, 133, 134) relative to the device under test (DUT), and the inspecting operation is configured for evaluating the defects of the device under test (DUT).

13. The image capturing combination adjusting method according to claim 12, **characterized in that** the step of screening the image capturing combinations (159) according to the image capturing results of the image capturing combinations (159) comprises:
determining whether the image capturing results of the image capturing combinations (159) are suitable for the inspection operation;
retaining the image capturing combinations (159) suitable for the inspection operation; and
eliminating the image capturing combinations (159) that are not suitable for the inspection operation.
